# EUROPEAN PATENT SPECIFICATION

(11) **EP 2 302 566 B1**
(45) Date of publication and mention of the grant of the patent: **27.03.2013**
(21) Application number: 09012053.6
(22) Date of filing: 22.09.2009
(51) Int. Cl.: G06K 19/077, H05K 1/18

(54) **Method for connecting at least one wire conductor disposed on a substrate with a chip of a transponder unit**
Verfahren zum Anschließen von mindestens einem Drahtleiter auf einem Substrat mit einem Chip in einer Transpondereinheit
Procédé de connexion d'au moins un conducteur de raccordement disposé sur un substrat avec une puce d'unité de transpondeur

(43) Date of publication of application: 30.03.2011
(73) Proprietor: ats Automation Technology Services, Collooney Sligo (IE)
(72) Inventor: Hynes, Fergus, Strandhill, Co. Sligo (IE); Finlay, Garreth, Ballymote, Co. Sligo (IE)
(74) Representative: Misselhorn, Hein-Martin

(56) References cited:
- EP-A1- 2 040 201
- WO-A1-2008/037579
- DE-A1- 19 701 163
- DE-U1-202007 013 680

## Description

The invention relates to a method for connecting at least one wire conductor disposed on a substrate with a chip of a transponder unit according to the preamble of claim 1.

Essential elements of a transponder unit are a coil device disposed on a substrate, said coil device being formed of a wire conductor. Furthermore, such a transponder unit usually comprises an electronic circuit configured as a chip. In order to bond the coil device to the chip, terminal areas are provided on the chip to which sections of the wide conductor, in particular end portions of the coil device, are attached, so that a conductive connection is established between the coil device and the chip. The wire conductor of such a coil device usually is a copper wire which as a rule has a diameter of between 40 µm and 60µm. In plan view, the terminal areas of the chip are square or rectangular and have side lengths of approx. 0.1 mm to 0.15 mm. The chip is a substantially flat-plate-shaped structure, which in plan view is rectangular, with a side length of, for example, 8 mm and a width of, for example, 5 mm. An electronic circuit covered with a ceramic material is disposed approximately centrally on a carrier member having these dimensions. The surface area of the ceramic material is approximately 5 x 5 mm, so that partial areas of the carrier member protrude at the sides of the surface of this ceramic material. The terminal areas are disposed on these partial areas of the carrier member. In this case, the terminal areas are usually placed very close to the edge of the carrier member and are connected with the corresponding inputs of the chip in an electrically conductive manner.

In a finished transponder unit, the chip, together with its carrier member, is disposed in a window recess of a substrate which has a large surface relative to the surface of the carrier member. The substrate serves the purpose of accommodating the coil device formed by the wire conductor. The electronic circuit, which is provided with the ceramic cover, and the carrier member form a chip device comprising the above-described terminal areas.

It is the purpose of the invention to specify a method with which the wire conductor of the coil device can be directly attached to the chip device at its terminal areas, without an interposition of other bonding devices.

Such a method is known from EP 0 880 754 B1. In this method, in a first method step, the wire conductor is applied onto the substrate in the form of a coil by means of a wire feeding device. The wire conductor is anchored on the substrate by means of conventional fixing methods, for example, by means of ultrasonic welding. In the process, end portions of the coil device are guided across a recess of the substrate such that the wire conductor portions spanning the recess come to lie in the area in which the terminal areas of the chip device are located after the chip device is inserted into the recess. This insertion of the chip device into the recess takes place subsequent to laying and fixing the coil and the wire conductor forming the coil. As a result, end portions of the wire conductor are spanned in predetermined areas corresponding with the future position of the terminal areas over a recess window, which at first is vacant. After the chip device has been inserted into the recess, the partial areas of the wire conductor, in plan view, already lie directly over the terminal areas. Following this method step, the wire conductors are attached to the terminal areas in the area of the terminal areas by means of conventional fixing methods, such as welding or soldering. In these methods, it is necessary that the wire conductor be laid with great precision in the area of the recess, in particular in the area of the terminal areas. Moreover, adapting the laying of the wire conductor to, for example, different positions of the terminal areas that depend on the chip always necessitates reprogramming the wire laying plant, which accounts for relatively long set-up times.

The fact that the wire conductors in this method lie relatively loosely across the window of the chip module, so that an exact positioning of the wire sections relative to the terminal areas of the subsequently inserted chip is not always ensured, constitutes another problem.

A method for connecting a wire conductor with terminal areas of a chip, wherein the wire conductor is disposed in a coil shape on a substrate, is known from EP 2 040 201 A1. It is disclosed that end portions of the wire conductor forming the coil are laid in the area of a recess for a chip module, i.e., in plan view, over the recess or in its peripheral vicinity in the form of a free loop which is not connected with the substrate and is raised slightly from the plane of the substrate. Free wire ends adjacent to the loop are connected with the substrate so that an essentially arcuate three-dimensional shape of the wire conductor raised from the plane of the substrate is provided. Grippers which are supposed to grip the arcuate wires and guide them in a defined manner towards the terminal areas of the chip module are provided in order for the wire conductor to be connected with a chip module or with its terminal areas, respectively. Once the wire loops have been guided to the terminal areas, they are attached there. In the process, the wire loops may tear off in the area of the ends of the wire conductor, which is accepted in this case. As a consequence, torn-off end portions of the wire conductor are disposed in space in an undefined manner because there is no attachment at the ends anymore. Moreover, it cannot be excluded that, after one of the partial sections forming the wire loop has been attached, the other loop areas may form secondary surplus loops on the terminal areas which may be raised from the substrate and which, moreover, are not connected to the substrate or to the carrier unit of the chip. Undesired snagging may thus occur during the further course of the production process which may lead to the destruction of the transponder unit which has just been produced.

Another drawback is that, during the insertion of the chip, wire conductor areas of the free loop must be positioned over to the terminal area relative to it in plan view and must be pressed onto the terminal areas in a vertical direction relative to the substrate surface so that bonding occurs. Such a sequence of movements is extremely complicated and error-prone in view of the small dimensions of both the wire conductor and the terminal areas.

In particular, a defined laying, or defined path, of the wire conductor in the area of the secondary loop forming is therefore not ensured. These secondary loop areas of the wire conductor may be damaged in subsequent processing steps, for example when the transponder unit is laminated on the top and/or bottom side, so that the transponder unit becomes inoperative.

It is another drawback that the wire loops must be positioned correctly relative to the terminal areas by means of positioning devices after the chip module has been inserted. At that point in time, however, gripping a very thin wire in the immediate vicinity of the substrate surface is difficult, so that, possibly, the wire may slip off the positioning device or slip out of the positioning device in the vertical vicinity of the substrate surface. The main reason for this is that the feeding devices cannot be lowered completely down to the surface of the substrate or the chip, so that the latter is not damaged by linear movement of the former for positioning the wire conductor. Thus, a gap between the chip and the feeding devices must remain. Given the only small thickness of the wire amounting to approximately 50 µm, it cannot always be prevented from slipping out.

Another drawback of this method is that, before the wire conductor can be attached to the terminal areas, the chip must be fixed relative to the substrate in order for a correct guidance of the wire loop to be possible. Such a fixation of the chip relative to the substrate is not always ensured, for example because tolerances of the outline of the chip relative to the window section in the substrate are not always within the limits specified. This may lead to unwanted movement of the chip relative to the substrate, which comes down to a corresponding inaccuracy of the positioning of the wire loops relative to the terminal areas. It is another drawback that the available options for arranging the chip relative to the coil are limited in this method. For example, the chip window must keep a minimum distance to the coil so that adjacent or closely adjacent coil windings are not damaged by the gripper when the wire coils are being gripped and positioned. This constitutes an unwanted limitation of the freedom of design and the variability with regard to positioning the chip relative tive to the coil. This is not wanted since it means that the chip, in the case of a rectangular substrate as it is the case, for example, in chip cards, must be disposed as far centrally of the substrate as possible because the windings of the coil device, that is, the path of the wire conductor, are disposed as far outwardly as possible in the edge area of the substrate. This, however, is disadvantageous in that, when such a chip card is bent, the largest deformations and thus the largest stresses occur especially in the centre of the chip card, which can lead to the chip being damaged undesirably in the finished chip card. It is also desirable to create a possibility which allows positioning the chip as close as possible to the edge of the substrate, because there, the bending stresses and the deformations during the use of such a chip card are minimised.

The patent application WO 2008/037579 A1 discloses a similar method for connecting a wire conductor with terminal areas of a chip, similar to the one disclosed in EP 2 040 201 A1, in which end portions of an antenna wire are provided in the form of free standing loops outside of the window, into which the transponder chip is later installed. The loop portions of the antenna wire are repositioned and connected to the transponder chip after this chip has been installed. A similar method is also disclosed in WO 2008/114091 A2. Both of these methods have similar drawbacks to the ones discussed in regard to the method known from EP 2 040 201 A1.

It is therefore the object of the invention to specify a method for connecting at least one wire conductor disposed on a substrate with a chip of a transponder unit which permits positioning the chip window as close as possible to the edge of the substrate, i.e. as close as possible to the path of windings of the coil device, so that it is ensured that the chip is subjected to as little strain as possible during use.

Furthermore, it is desirable to create a method in which the wire conductor can be connected in a simple manner with different chips, the terminal areas of which are disposed at different locations. In particular, this is of course supposed to be possible without having to adapt the path of the wire conductor on the substrate when it is attached. Thus, a method is to be specified which makes it possible in a simple manner to adapt uniformly laid wire conductors to different positions of terminal areas and connect them with them.

Furthermore, a method is to be specified which permits the laying tolerances of the wire conductor for forming the coil device to be selected relatively large. In particular, the requirement of camera monitoring during the laying of the wire conductor on the substrate is to be avoided.

Moreover, a method is to be specified which permits providing those wire sections which, in plan view onto the finished transponder unit, extend across the chip module, with a defined tension in the area of the chip module window. This precludes micro-movements in the area of the terminal areas due to lack of tension, so that an improved long-term bond of wire to the terminal areas is ensured.

These objects are achieved with a method according to claim 1.

Advantageous embodiments are specified in the dependent subclaims.

The method according to the invention according to the preamble of claim 1 is characterised, according to the invention, in that, in a first method step, end portions of the wire conductor, which are laid across a vacant window, that is, a window not occupied by a chip, in a central area, wherein they extend spaced at a distance from one another. These sections of the end portions of the wire conductor extending across the window are displaced from the central area, i.e. from their initial position, towards a corresponding edge of the accommodating window by means of a positioning device, namely in the direction of a terminal area of the chip module later to be inserted. Displacement is carried out exactly to the point where at least a section of the partial area extends over the desired position of the terminal area. The chip module is subsequently inserted into the accommodating window and the section located over the terminal area is then connected in an electrically conductive manner with the terminal area.

It is a particular advantage of the invention that the accommodating window is vacant at the time of positioning the wire sections spanned across the vacant accommodating window, so that the positioning devices or parts of the positioning devices, respectively, can dip into this window, so that the wire conductor can be safely and reliably gripped and displaced towards its desired position.

Furthermore, it is a particular advantage that relatively large-scale inaccuracies are acceptable when the wire conductor is laid across the accommodating window, so that the effort in laying the wire conductor onto the substrate is relatively easy to manage. Because the only essential issue according to the invention is that the partial areas of the wire conductor spanning across the accommodating window are arranged in a central area of the window. Within the meaning of the invention, a central area is to be understood to mean an area within the terminal areas of the chip, so that the wire conductor sections can be positioned in their desired position by being displaced in the direction towards the corresponding edge of the accommodating window. Because the chips or chip modules, respectively, usually comprise a rectangular three-dimensional form with a rectangular carrier member on which an electronic chip is disposed, for example, centrally, and since this chip is usually covered with a ceramic layer, the area of the ceramic cover of the electronic chip can be considered the central area in the example of a chip thus configured. In these chips, the terminal areas for the conductor wires are disposed laterally from the electronic circuit covered with the ceramic layer.

According to the invention, it was shown that laying the wire conductors across a central area of the accommodating window with relatively large tolerances entails considerable savings and a considerable simplification of the laying process. In particular, the laying process does not have to be monitored by camera in order to comply with the required positional tolerances. Starting from this initial position, a highly precise positioning of the wire ends can be ensured with a relatively small mechanical effort by using a positioning device for spreadingly displacing the wire ends. A safe gripping of the wire conductor by the positioning device is ensured by the fact that the accommodating window is still vacant at the time of the spreading displacement of the wire ends, so that positioning devices can dip into it or can dip through it, and that a safe gripping of the wire conductor is thus ensured. The wire conductor is thereby reliably prevented from slipping away from or off from the positioning device.

According to a preferred embodiment of the invention, a wedge that can be moved and conveyed, for example, vertically relative to the substrate, has proven its value as a positioning device, the wedge dipping in between the spaced-apart sections of the wire conductor, wherein the sections are moved away from one another until they have reached their desired position over the terminal areas of the chip module inserted thereafter.

According to the invention, it was found, surprisingly, that rebound effects of the spread wire conductor sections due to elastic deformation of the wire conductor are very small or are not present at all during the displacement by means of the positioning device. The reason for this is that the elements of the positioning apparatus that cooperate with the wire sections are configured to be sharp-edged so that the wires are, for the most part, plastically deformed, thus avoiding or keeping rebounding within tolerable limits. Another explanation for the rebounding effects not being present is that the connection of the conductor wires with the substrate adjacent to the accommodating window is at least partially detached by the spreading, so that a sufficient length of wire is provided in order to form the spreading path of the wires.

According to another advantageous alternative of the invention, a spreading fork is used as the positioning device, which first dips in between the wire sections in a closed state and then displaces these wire sections into their desired position by opening the spreading fork. What is particularly advantageous in this embodiment is that the wires can be displaced from the initial position by varying distances by independently controllable spreading fork prongs, and that thus, an adaptation of the final position of the wire sections to the future position of the terminal areas can take place in a simple manner. In the case of a wedge, this can be accomplished, for example, by wedge flanks that come into contact with the wire having a different inclination angle relative to the central axis, so that the displacement of the wire sections takes place over varying distances while the depth of the dipping of the wedge remains the same.

According to another alternative embodiment of the invention, the positioning device is configured as a pair of hook devices, wherein one hook device respectively cooperates with one wire section spanned across the accommodating window. After the wire has been gripped, the hook device is moved towards the corresponding outer edge of the accommodating window and thus provides for a displacement of the corresponding wire section. What is particularly advantageous in this embodiment is that in this case, the hook members are only required to dip below the substrate plane in a small extent in order to ensure a sufficient gripping of the wire. This makes it possible, in particular by resilient mounting of the hook members, to insert the chip or the chip module into the vacant accommodating window while the hook device is still in contact with the wire. This is possible because it is not necessary for the hook devices to reach far through the accommodating window. This advantage is also the result of spreading forks with a corresponding geometric design as they were described above.

It is particularly preferred to provide a pair of hook forks as hook devices, with the hook forks comprising fork prongs that are disposed spaced apart from one another. In this development of the positioning device, the wire section can be connected with the terminal area by means of a fixing device, for example a welding device, reaching through between the hook fork prongs, while the wire is still held and positioned by the hook device. This constitutes a particularly reliable way of positioning and connecting the wire sections with the terminal areas.

Furthermore, it is advantageous to bring the positioning devices out of engagement with the wire sections prior to fixing the wire sections. This is advantageous in that, at the point in time of the insertion of the chip module into the accommodating window, the latter is free of components of the positioning device and thus readily accessible. Moreover, it may be advantageous, particularly for example when using a hook-type positioning device, that the wire section disposed across the accommodating window for the chip module is also lifted a bit vertically from the substrate surface when it is displaced. Possible stresses present in the wire may thereby be relieved by detaching the wire from the substrate in the surrounding area around the accommodating window, and a particularly precise positioning may thus be accomplished.

In order to facilitate the detachment of the wire conductors in the vicinity of the accommodating window, it is expedient to make sure, already when the wire conductor is applied onto the substrate, that the strength of the connection of the wire conductor with the substrate is configured to be slightly weaker in a defined vicinity around the accommodating window. For example, this may be done by reducing the connecting energy which is applied, for example, within the context of ultrasonic connecting techniques, in the area around the accommodating window. A connection of the wire conductor with the substrate having a lower strength, which facilitates the detachment, is thereby produced.

In order to prevent or minimise rebounding effects of the wire to an acceptable level, it is expedient to select the radii of corner areas of the positioning device, around which the wire extends during the spreading displacement, to be particularly tight, so that a plastic deformation occurs locally in these areas and thus, a stiffening or solidification of the wire, which counteracts the rebounding tendencies. Useful corner radii are in a range of between 0.05 mm and 0.15 mm in the area of the edges of the positioning device that cooperate with the wire. A radius of < 0.1 mm has proven to be particularly valuable.

The invention is explained in more detail below by way of example with reference to the drawing. In the figures:
- Figure 1:: shows a perspective detailed view onto a substrate with wire conductor ends laid across a central area of an accommodating window;
- Figure 2:: shows a plan view of the initial situation according to Fig. 1;
- Figure 3:: shows a plan view onto the initial situation according to Fig. 1, with the position of the ends of the wire conductors relative to the chip module being depicted for illustration purposes;
- Figure 4:: shows a plan view of the detail according to Figs. 1/2 after the wire conductor ends have been spreadingly displaced;
- Figure 5:: shows the situation according to Fig. 4 with a chip module drawn in;
- Figure 6:: shows a perspective view onto an initial situation according to Fig. 1 with a schematically indicated positioning device of a hook-type first embodiment;
- Figure 7:: shows a second perspective representation of the embodiment according to Fig. 6 with a hooked positioning device;
- Figure 8:: shows the first embodiment of the invention with spread wire ends;
- Figure 9:: shows the method step of connecting the wire conductor with the terminal areas in a perspective view;
- Figure 10:: shows the situation according to Fig. 9 in plan view;
- Figure 11:: shows a perspective view onto the situation according to Fig. 10;
- Figure 12:: shows an initial situation of a second embodiment of the method according to the invention with a spreading-fork-type positioning device;
- Figure 13:: shows the method of the invention according to Fig. 12 with a dipped spreading fork;
- Figure 14:: shows the method according to Figs. 12 and 13 with a spreading fork spread open;
- Figure 15:: shows the method according to Figs. 12 and 14 with a retracted spreading fork;
- Figure 16:: shows the method according to Figs. 12 to 15 with wire conductor sections attached on the chip;
- Figure 17:: shows a third embodiment of the method according to the invention with a wedge-type positioning device in an initial situation;
- Fig. 18:: shows the method according to Fig. 18 with a wedge dipped for spreading the wire conductor sections.

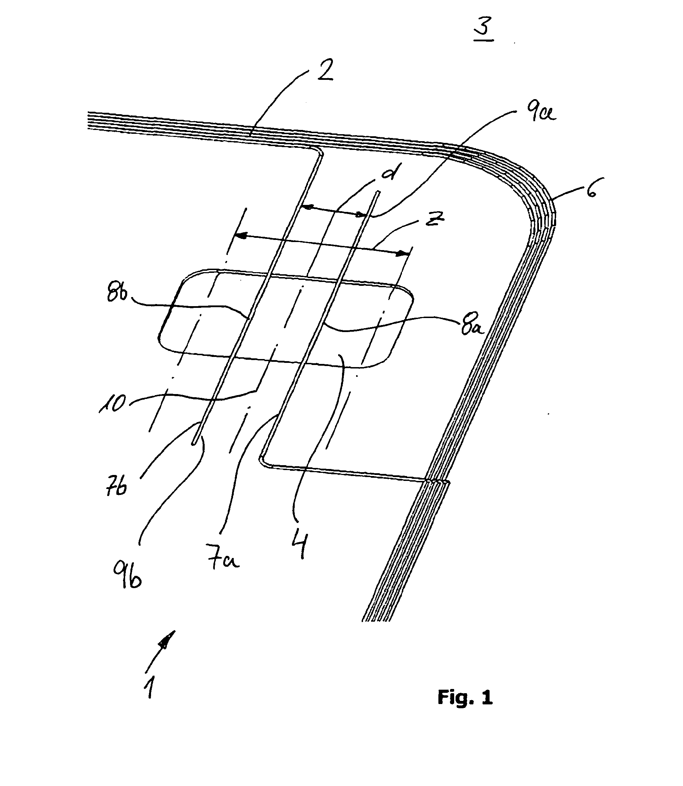

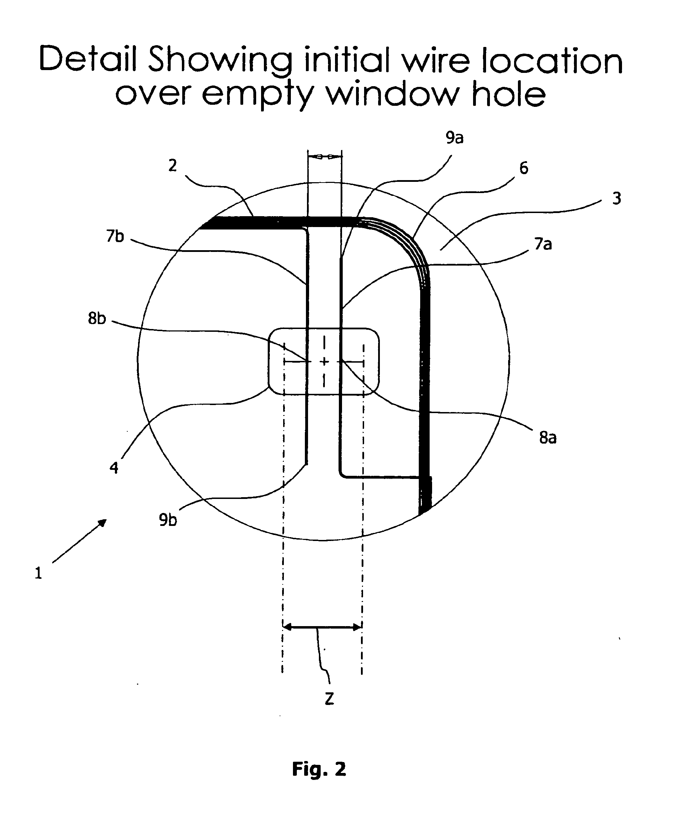

The method according to the invention is generally explained below with reference to the Figures 1 to 5.

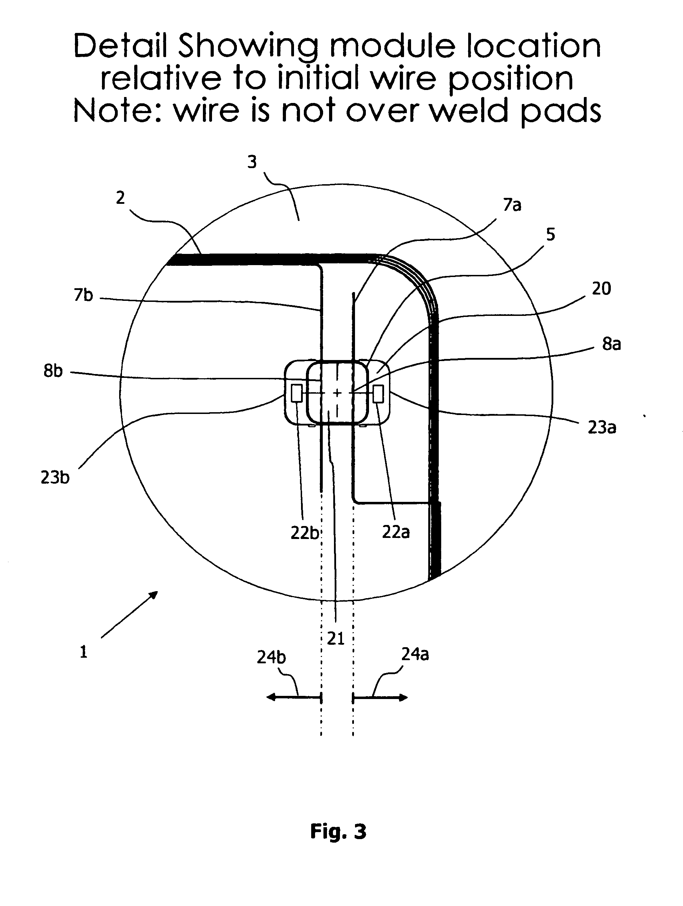

Fig. 1 shows a detail of a transponder device 1 with a coil device 2 disposed on a substrate 3. The substrate 3 comprises an accommodating window 4 for a chip module 5 (see Fig. 3, shown therein). The coil device 2 is formed of a wire conductor 6 which is connected with the substrate 3, for example by means of a ultrasonic welding method. The wire conductor 6 comprises end portions 7a, 7b spanning across the accommodating window 4 in a central area Z. Partial areas 8a, 8b of the end portions 7a, 7b of the wire conductor 6 thus span across the accommodating window 4. Free ends 9a, 9b of the wire conductor are connected to the substrate 3. The end portions 7a, 7b, in an initial position according to Fig. 1, are spaced apart at a distance d and are disposed symmetrically to a central axis 10 of the accommodating window 4 in the exemplary embodiment according to the Figures 1 to 5. Of course, the end portions 7a, 7b can also be disposed at different distances from the central axis 10. What is essential is that the end portions 7a, 7b are arranged such that the partial areas 8a, 8b come to lie in the central area Z of the accommodating window. The central area is explained in more detail below with reference to Fig. 3.

For illustration purposes, the initial position of the end portions 7a, 7b or the partial areas 8a, 8b, respectively, is shown in Fig. 3 relative to the chip module 5 to be inserted, with the chip module 5 being drawn in. The chip module 5 comprises a carrier member 20 which approximately has the three-dimensional shape of the window section of the accommodating window 4. An electronic circuit covered by a cover 21, for example a ceramic cover, is arranged approximately centrally in the middle on the carrier member 20. Terminal areas 22a, 22b of the chip module 5 with which the wire conductor 6 is to be contacted are located laterally next to the cover 21. According to the invention, the area located between the terminal areas 22a, 22b is considered the central area Z. In order for bonding of the partial areas 8a, 8b to the terminal areas 22a, 22b to be possible, they must be outwardly displaced from the central area Z towards corresponding edges 23a, 23b of the accommodating window 4. According to the invention, the partial areas 8a, 8b are thus displaced in a direction along the arrows 24a, 24b from the initial position according to the Figures 1 to 3 to the point where the partial areas 8a, 8b come to lie over the terminal areas 22a, 22b in a plan view according to Fig. 3.

In this case, it is actually desirable that the connection of the end portions 7a, 7b of the wire conductor 6 on the substrate 3 breaks up in a controlled manner in the immediate vicinity around the accommodating window 4, so that a certain desired longitudinal stress is thus generated in the wire conductor 6.

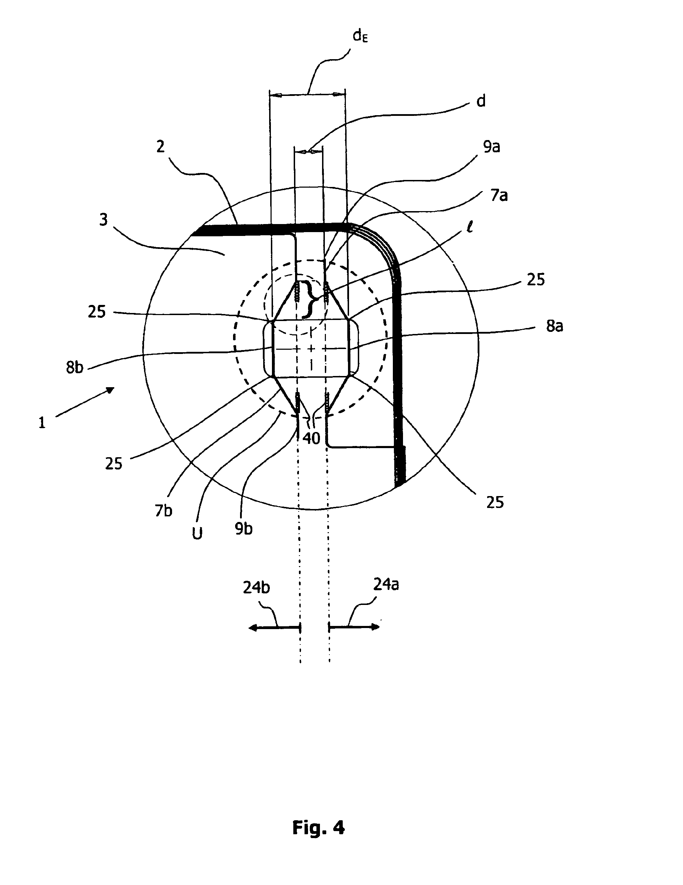

Fig. 4 shows such a situation with spread partial areas 8a, 8b, wherein it must be emphasised that, in the method according to the invention, the partial areas 8a, 8b are spread preferably prior to the chip module 5 being inserted into the accommodating window 4.

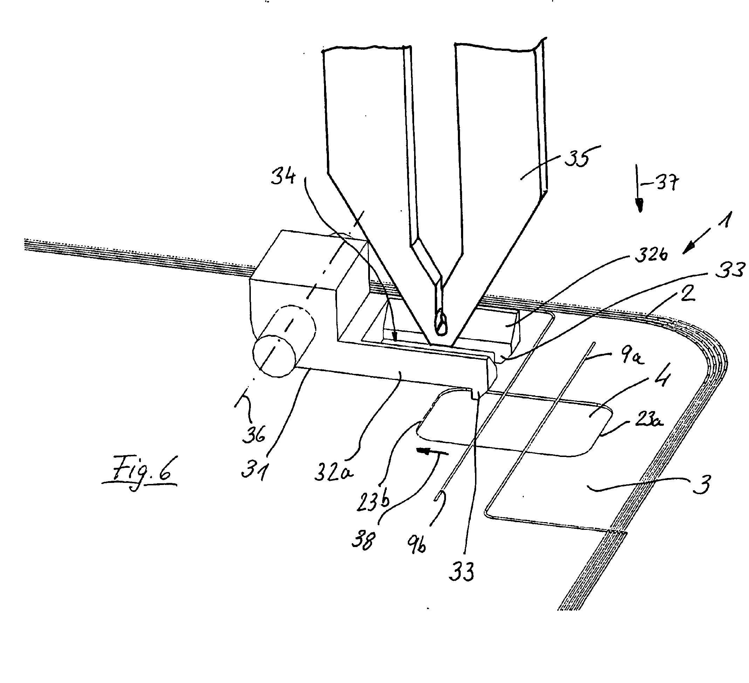

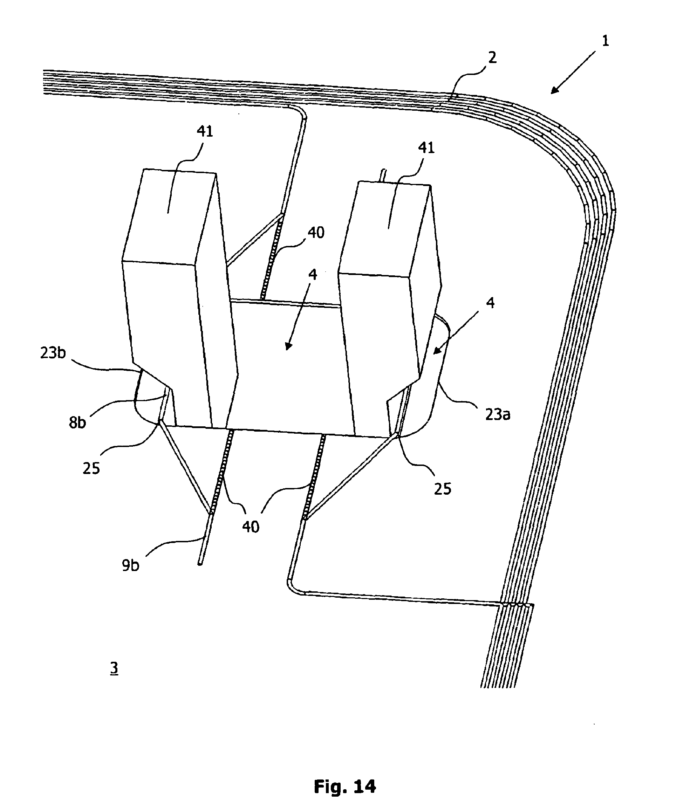

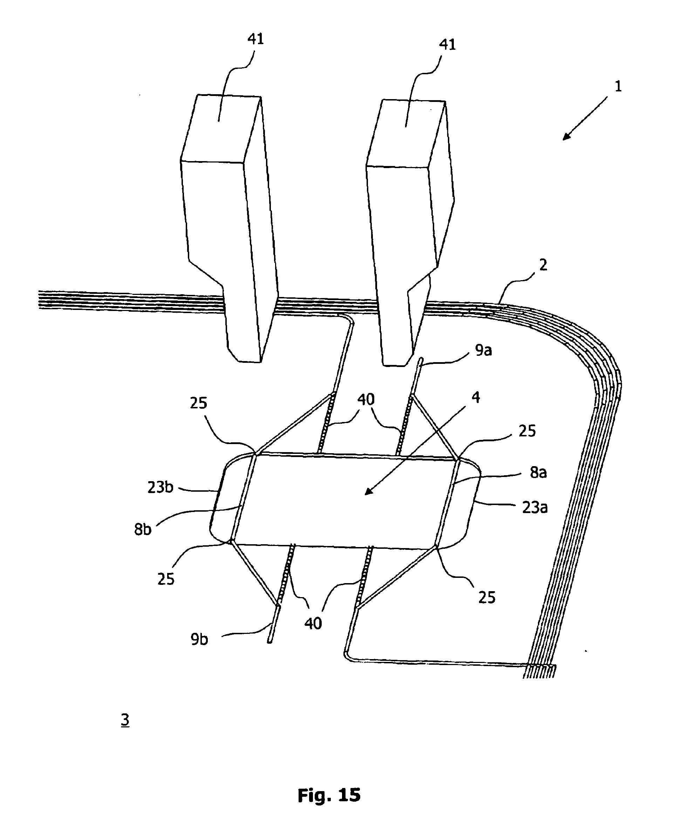

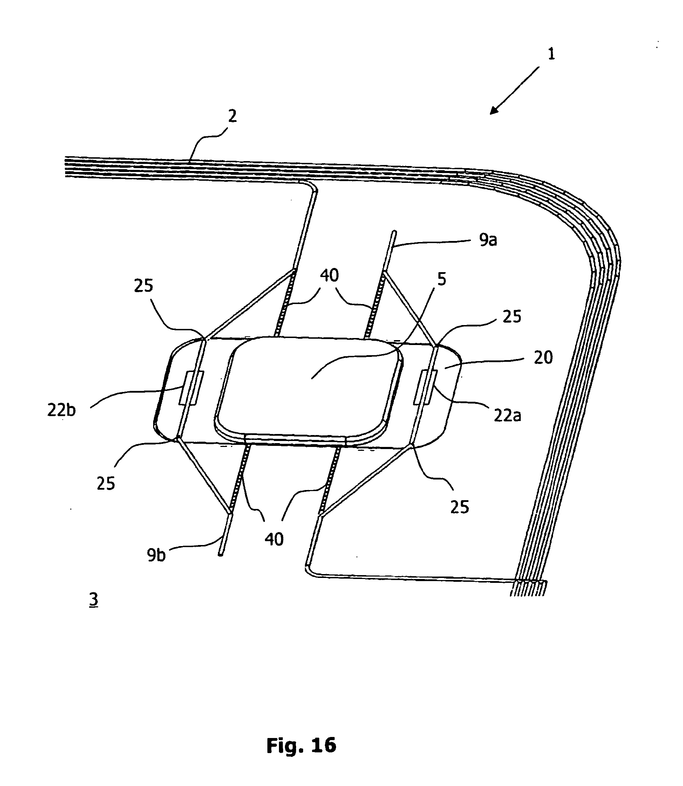

Spreading and positioning the partial areas 8a, 8b is accomplished by means of suitable positioning devices, with three possible embodiments of the positioning device preferably to be used being described below with reference to the Figures 6 to 19.

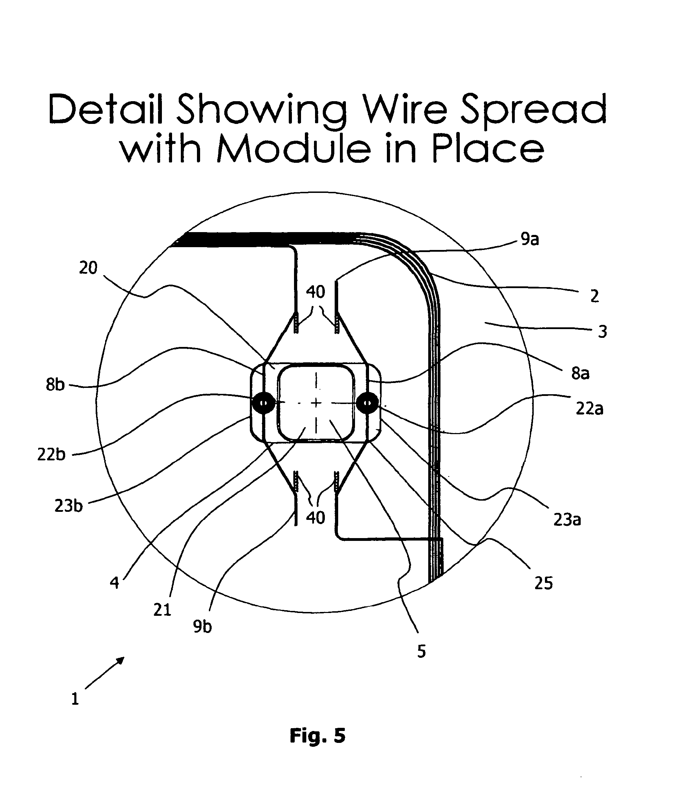

After spreading the partial areas 8a, 8b (intermediate state according to Fig. 4), the chip module 5 is inserted into the accommodating window 4. Here, the partial areas 8a, 8b in plan view lie over the corresponding terminal areas 22a, 22b of the chip module 5. This state is depicted in Fig. 5.

After the insertion of the chip module 5, the partial areas 8a, 8b are connected in an electrically conductive manner with their corresponding terminal areas 22a, 22b. This is usually done by welding, soldering or other suitable connecting methods. The method according to the invention is completed after the connection of the partial areas 8a, 8b. The transponder device 1 thus produced can be transferred to further process steps, for example laminating steps, in order to be finished completely.

For chip modules 5 having usual dimensions, a range of from 1.5 mm to 3.5 mm, in particular 2 mm to 3 mm, has proven valuable as a suitable distance d. Within this range, the distance d is, on the one hand, sufficiently large for being able to reach between the partial areas 8a, 8b easily and unimpeded using positioning devices as they are described below. On the other hand, the displacement distance between the initial position of the partial areas 8a, 8b and their final position is large enough to reliably ensure a defined detachment of the wire conductor 6 adjacent to the accommodating window 4 and thus realise the desired stress in the wire. The distance d can expediently be proportionally increased or reduced for correspondingly larger or smaller chip modules.

When the partial areas 8a, 8b are being spread, the wire conductor 6 is subjected to bending 25 at positioning members of the positioning device, the bends constituting areas of plastic deformation of the wire conductor 6. The wire conductor 6 is thereby plastically deformed and locally strengthened by cold forming in the area of the bends 25. Rebounding tendencies of the partial areas 8a, 8b after spreading towards the initial position can thus be reliably suppressed. In order for the bends 25 to be sufficiently large, the above-mentioned range d for the distance d is also recommended.

Using Fig. 4 as an example, an initial distance d of 2.5 mm is shown as an initial distance d to be understood as an example for a final distance dE of 6.5 mm, for example. It also becomes apparent from Fig. 4 that the wire conductor is detached from the substrate over a length 1 adjacent to the accommodating window when the partial areas 8a, 8b are spread. In order to ensure a defined detachment along a length 1 of the wire conductor 6, it is recommended to provide the initial fixation of the wire conductor 6 on the substrate 3 in a surrounding area U around the accommodating window 4 optionally with a lower strength, so that detachment along the length 1 is made possible in a simplified and defined manner. Configuring a fixation with a lower strength in this way can be accomplished, for example, by reducing the ultrasonic energy when the wire conductor 6 is laid in the surrounding area U, whereby the anchoring to the substrate 3 of the wire conductor 6 in the area U is configured to be less durable. Possibly, it is even expedient to completely dispense with the fixation of the wire conductor 6 within a surrounding area U around the accommodating window 4, so that it is possible for the wire conductor 6 to glide freely over the surface of the substrate 3 during spreading. In this case, it is expedient to carry the wire conductor 6 so far across the surrounding area U that its free ends 9a, 9b can be firmly connected with the substrate 3 outside of the surrounding area U.

If the displacement distance of the partial areas 8a, 8b from their initial position according to Fig. 1 to their final position according to the Figures 4, 5 is sufficiently small, the length compensation which becomes necessary due to the displacement may optionally be accomplished solely by elongating the wire, i.e. by an elastic deformation of the wire, so that a defined detachment of the wire in the surrounding area from the substrate is not absolutely necessary. Such an approach may make sense especially in the case of particularly small dimensions of the chip module 5, or in the case of positioning the partial areas 8a, 8b in the central area Z close to the terminal areas 22a, 22b.

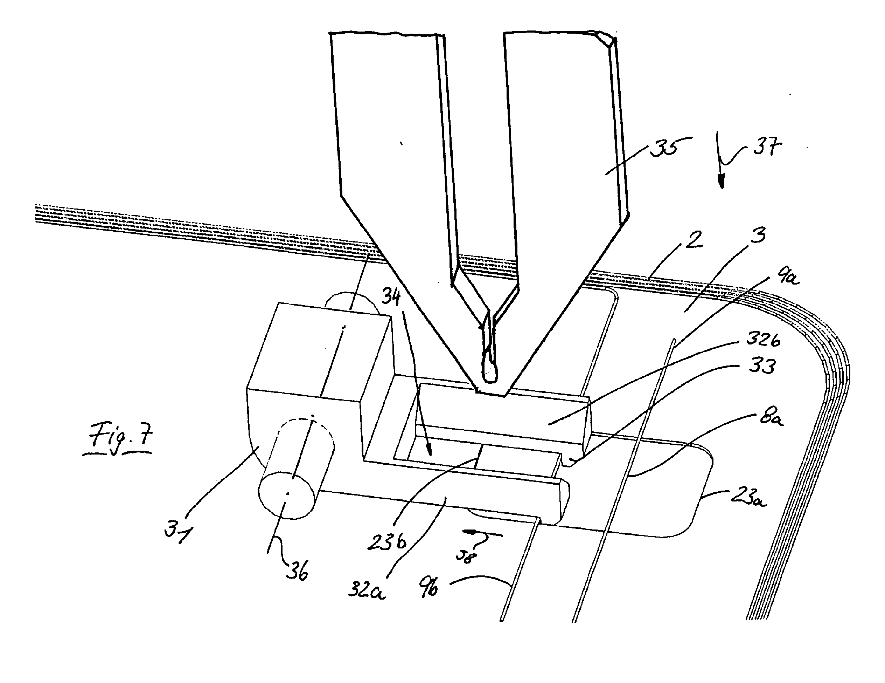

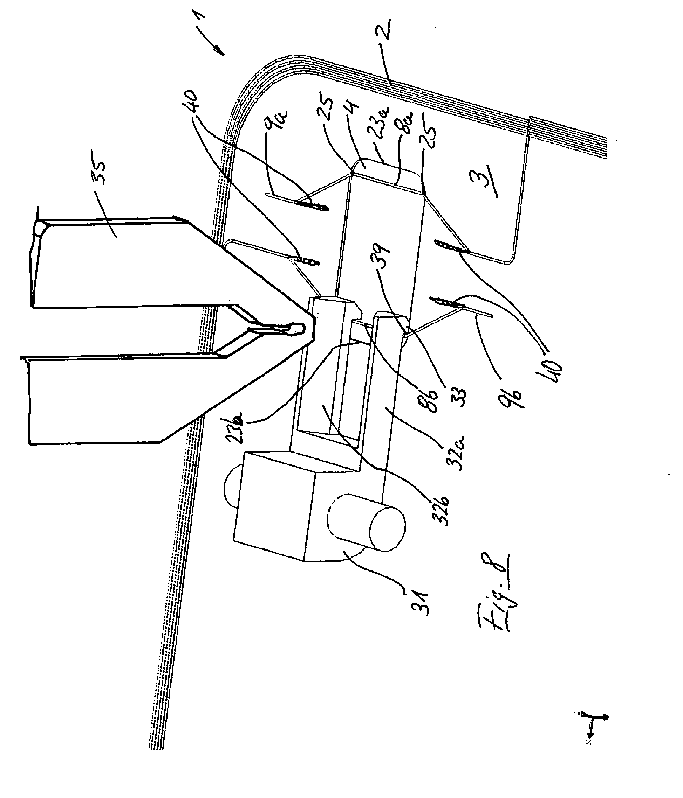

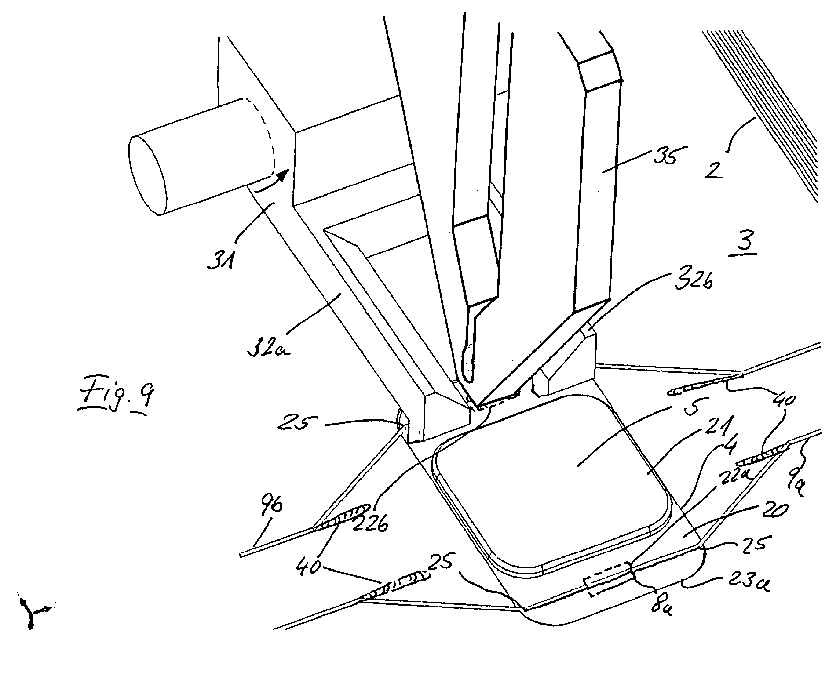

The method according to the invention is explained below by way of example with reference to the Figures 6 to 12, using a hook-type positioning device 30. Fig. 6 shows the initial situation for the method according to the invention according to Fig. 1, with a hook-type positioning device being shown as the positioning device 30. A hook fork 31 is allocated to each of the partial areas 8a, 8b, with only one hook fork 31 being shown in the Figures 6 to 9 in order to simplify the illustration. Each hook fork 31 comprises two hook fork prongs 32a, 32b, each of which comprise hook projections 33. A clearance space 34 is provided between the hook fork prongs 32a, 32b, into which a welding electrode 35 can reach. The hook forks 31 are mounted pivotably about a pivot axis 36. The hook forks 31 as well as the welding electrode 35 can be moved towards and away from the surface of the substrate 3 vertically or substantially vertically in a vertical direction 37. Moreover, at least the hook forks 31 are movably shiftable in a displacement direction 38 in order for the partial areas 8a, 8b of the wire conductor 6 to be movable along the displacement direction 38 towards the respectively corresponding edge 23a , 23b of the accommodating window 4. In a first step, the hook forks 31 are moved along the vertical direction 37 towards the substrate 3 until the hook projections 33 grasp the sections 8a, 8b of the wire conductor (compare Fig. 7). In a next step, the hook forks 31 are moved along the displacement direction 38 (compare Fig. 8), with the sections 8a, 8b being moved towards the respectively corresponding edges (23a, 23b). Sharp-edged bends 25 are thus produced, formed by edges 39 of the hook projections 33 during displacement along the displacement direction 38. A radius value of < 0.15 mm, in particular, of < 0.1 mm, has proven to be particularly valuable as an edge radius of the edges 39. When the partial areas 8a, 8b are displaced, the wire conductor 6 is detached from the substrate in the vicinity of the accommodating window 4, so that traces of breaking 40 become visible. At the end of this spreading step, the partial areas 8a, 8b are located in their desired position. The chip module 5 is then inserted into the accommodating window 4 of the substrate 3 from the side opposite to the wire conductor (compare Fig. 9). In the process, the hook fork 31 is slightly pivoted upwards about the pivot axis 36. The partial areas 8a, 8b lie above the terminal areas 22a, 22b and are now welded to the terminal areas by means of the welding electrode 35.

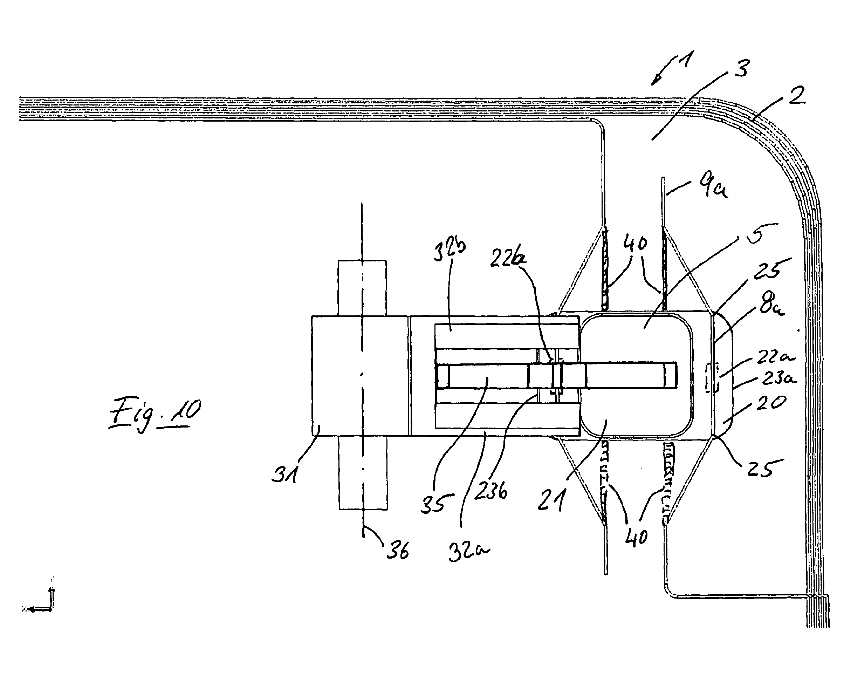

Fig. 10 shows the situation according to Fig. 9 in plan view.

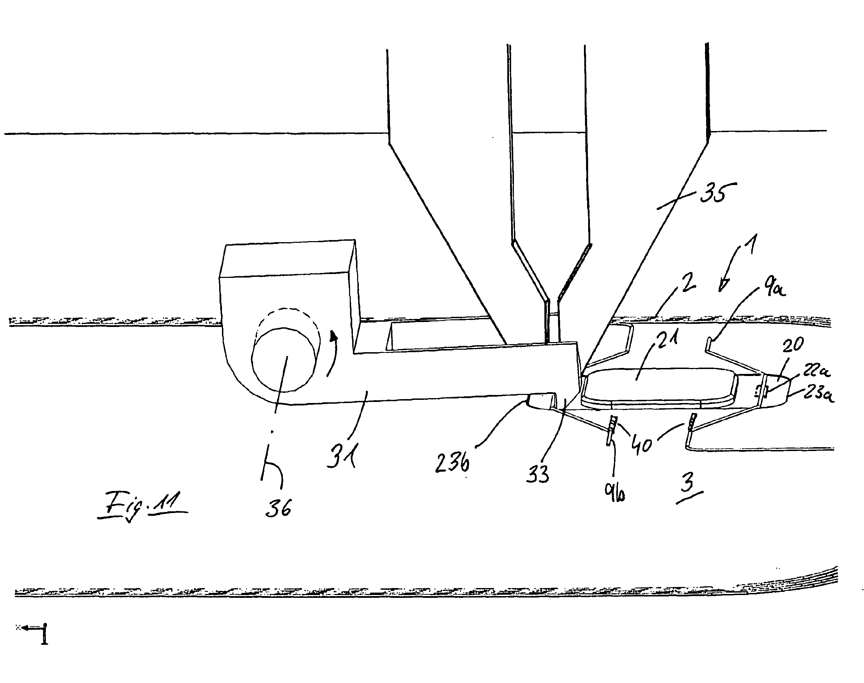

Fig. 11 shows the situation according to Fig. 9 in a modified perspective representation, wherein the hook fork is already pivoted slightly, so that the partial sections 8a, 8b are held in the area of a free end of the hook projections 33.

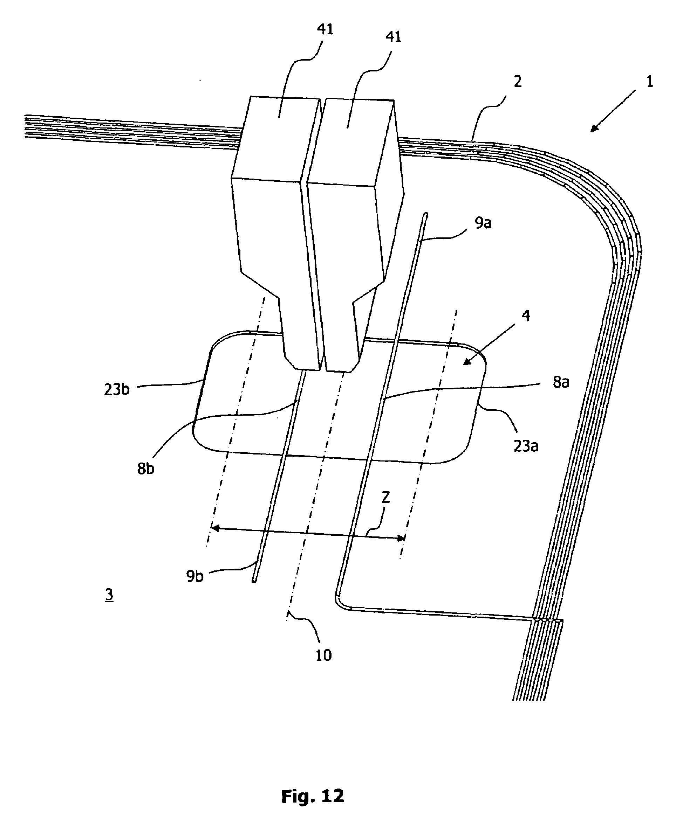

The method according to the invention is explained below with reference to the Figures 12 to 16, using a spreading-fork-type positioning device 30.

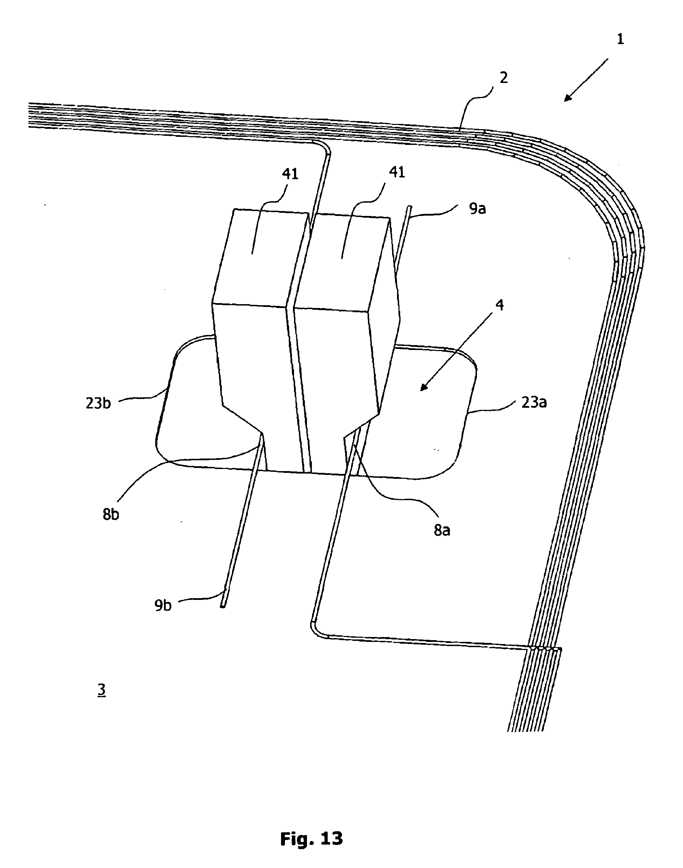

In an initial situation according to Fig. 12, the positioning device 30 comprising two spreading fork prongs 41 used for positioning and/or displacing the partial areas 8a, 8b. The spreading fork prongs 41, after the wire conductor 6 has been laid, are lowered along the vertical direction 37, dipping through in between the partial areas 8a, 8b and through the accommodating window 4. In the lowered state, one partial area 8a, 8b is respectively allocated to one of the spreading fork prongs 41 (compare Fig. 13). In a next step, the spreading forks are moved apart from each other in a displacement direction 38 so that the partial areas 8a, 8b are brought into their desired position. The bends 25 are produced in the process, which lead to cold-hardening and thus, stabilisation, of the wire conductor 6. Furthermore, parts of the end portions 7a, 7b of the wire conductor 6 are optionally detached from the substrate in a surrounding area around the accommodating window 4, whereby a defined stress is created in the wire conductor 6. Moreover, traces of breaking or detaching 40 are produced when the wire conductor 6 was fixed up to the edge or up to the vicinity of the edge of the accommodating window 4. After the partial areas 8a, 8b have been spread apart, the positioning device 30 with the spreading fork prongs 41 is moved upwards in the vertical direction 37, so that the accommodating window 4 is vacant for accommodating the chip module 5. The chip module 5 is subsequently inserted from below into the accommodating window 4 and the partial areas 8a, 8b are connected to the terminal areas 22a, 22b in the area of the latter.

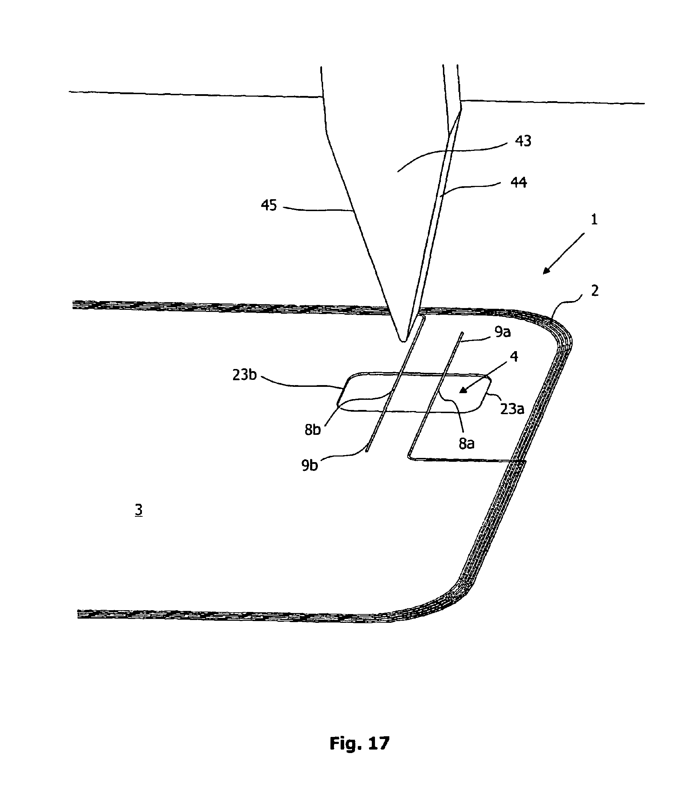

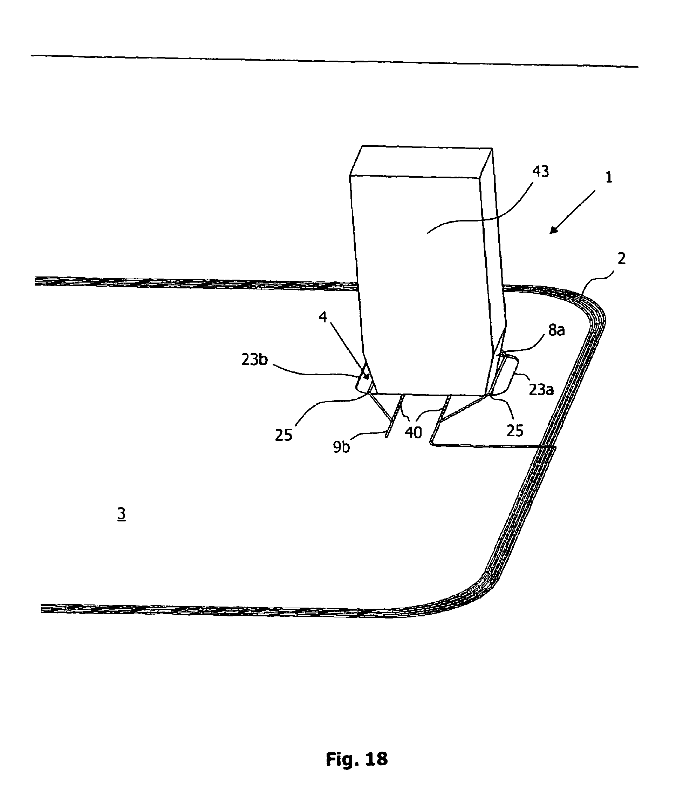

The method according to the invention is explained below with reference to the Figures 17 and 18, using a wedge-type positioning device 30. In an initial situation according to Fig. 18, the positioning device 30, which is configured as a wedge 43, is lowered in the vertical direction 37, dipping between the partial areas 8a, 8b through the accommodating window 4. The wedge 43 comprises wedge flanks 44, 45 which come into contact with corresponding partial areas 8a, 8b. The partial areas 8a, 8b are displaced into their desired position by continued lowering of the wedge 43 while the bends 25 are formed and, possibly, the traces of detachment 40 are formed. The wedge 43 is subsequently moved upwards opposite to the vertical direction 37. The chip module 5 can subsequently be inserted from below into the substrate 3 and the partial areas 8a, 8b can be connected to the accommodating areas by means of suitable fixing methods.

### List of Reference Numerals:

- 1: Transponder device
- 2: Coil device
- 3: Substrate
- 4: Accommodating window
- 5: Chip module
- 6: Wire conductor
- 7a: End portion of the wire conductor 6
- 7b: End portion of the wire conductor 6
- 8a: Partial area of the end portion 7a
- 8b: Partial area of the end portion 7b
- 9a: Free end of the wire conductor 6
- 9b: Free end of the wire conductor 6
- 10: Central axis of the accommodating window 4

- 20: Carrier member
- 21: Cover
- 22a: Terminal device/terminal area of the chip module 5
- 22b: Terminal device/terminal area of the chip module 5
- 23a: Corresponding edge of the accommodating window 4
- 23b: Corresponding edge of the accommodating window 4
- 24a: Directional arrow of displacement of the partial area 8a
- 24b: Directional arrow of displacement of the partial area 8b
- 25: Bends of the wire conductor 6

- 30: Positioning device
- 31: Hook fork
- 32a: Hook fork prong
- 32b: Hook fork prong
- 33: Hook projections
- 34: Clearance space between hook fork prongs 32a, 32b
- 35: Welding electrode
- 36: Pivot axis

- 37: Vertical direction
- 38: Displacement direction
- 39: Edges of Hook projections 33
- 40: Traces of breaking/detachment
- 41: Spreading fork prongs
- 43: Wedge
- 44: Wedge flank
- 45: Wedge flank

- Z: Central area of accommodating window 4
- d: Initial distance of end portions 7a and 7b
- dE: Final distance
- l: Length of detachment of wire conductor 6 from substrate 3
- U: Surrounding area around the accommodating window 4

## Claims

1. Method for connecting at least one wire conductor (6) with at least one terminal device (22a, 22b) of a chip module (5) for producing a transponder device (1) comprising a coil device (2) and said chip module (5), wherein, in a first method step, the coil device (2) is disposed and fixed on a substrate (3),and, in a further method step, the wire conductor (6) of the coil device (2) is connected to the chip module (5), whereby
during the first method step, end portions (7a, 7b) of the wire conductor (6) are laid so as to extend across a accommodating window (4) in a spaced-apart relation in a central area (Z) of the accommodating window (4) for the chip module (5), partial areas (8a, 8b) of the wire conductor (6) extending across the accommodating window (4) are displaced from said central area (Z) in a spreading manner towards an adjacent edge (23a, 23b) of the accommodating window (4) by means of a positioning device (30) until at least a section of the partial area (8a, 8b) extends over the desired position of a terminal area (22a, 22b), the chip module (5) is subsequently inserted from the side of the substrate (3) which is opposite to the side of the wire conductor (6) into the accommodating window (4) and the section is then connected in an electrically conductive manner with the terminal area (22a, 22b).

2. Method according to claim 1, **characterised in that** a wedge (43) is used as the positioning device (30), which dips between the partial areas (8a, 8b) and through the accommodating window (4), wherein the partial areas (8a, 8b) are spread away from one another.

3. Method according to claim 1, **characterised in that** a spreading fork with spreading fork prongs (41) is used as the positioning device (30), which dips between the partial areas (8a, 8b) and through the accommodating window (4), wherein the partial areas (8a, 8b) are spreadingly displaced towards the edge of the accommodating window (4) by opening.

4. Method according to claim 1, **characterised in that** a pair of hook devices (31) is used as a positioning device (30), wherein one hook device (31) respectively cooperates with one partial area (8a, 8b) and the latter is displaced from the central area (Z) towards the adjacent edge (23a, 23b) by means of the hook device (31).

5. Method according to claim 4, **characterised in that** a pair of hook forks (31) is used as the hook device (31) and that a fixing device, e.g. a welding electrode (35), acts upon the wire conductor (6) between the prongs of the hook forks (31) in order to connect the partial areas (8a, 8b) with the terminal areas (22a, 22b).

6. Method according to any one of the preceding claims, **characterised in that** the positioning device (30) is brought out of engagement with the partial areas (a, 8b) prior to the insertion of the chip module (5).

7. Method according to any one of the preceding claims, **characterised in that** the partial area (8a, 8b) is lifted a bit vertically relative to the surface of the substrate (3) during spreading.

8. Method according to any one of the preceding claims, **characterised in that** the partial areas (8a, 8b) are displaced by different distances from their initial position towards the adjacent edge (23a, 23b).

9. Method according to any one of the preceding claims, **characterised in that** the fixation of the wire conductors (6) on the substrate (3) is configured to be weaker in a margin area (U) around the accommodating window (4) than in the remaining area of the substrate (3).

10. Method according to any one of the preceding claims, **characterised in that** the wire conductor (6) is plastically deformed around edges (39) of the positioning device (30) with narrow radii during spreading.

## Patentansprüche

1. Verfahren zum Verbinden zumindest eines Drahtleiters (6) mit zumindest einer Anschlusseinrichtung (22a, 22b) eines Chipmoduls (5) zur Fertigung einer Transpondervorrichtung (1) mit einer Spuleneinrichtung (2) und dem Chipmodul (5), wobei in einem ersten Verfahrensschritt die Spuleneinrichtung (2) auf einem Substrat (3) angeordnet und befestigt wird und in einem weiteren Verfahrensschritt der Drahtleiter (6) der Spuleneinrichtung (2) mit dem Chipmodul (5) verbunden wird, wodurch während des ersten Verfahrensschrittes Endbereiche (7a, 7b) des Drahtleiters (6) in einem Zentrumsbereich (Z) des Aufnahmefensters (4) für das Chipmodul (5) beabstandet zueinander über ein Aufnahmefenster (4) verlaufend verlegt werden, über das Aufnahmefenster (4) verlaufenden Teilbereiche (8a, 8b) des Drahtleiters (6) mittels einer Positioniervorrichtung (30) vom Zentrumsbereich (Z) in einer spreizenden Weise auf einen benachbarten Rand (23a, 23b) des Aufnahmefensters (4) hin versetzt werden, bis zumindest ein Abschnitt des Teilbereichs (8a, 8b) über der Soll-Position einer Anschlussfläche (22a, 22b) verläuft, anschließend das Chipmodul (5) von der der Seite des Drahtleiters (6) gegenüberliegenden Seite des Substrats (3) in das Aufnahmefenster (4) eingebracht wird und daraufhin der Abschnitt mit der Anschlussfläche (22a, 22b) elektrisch leitend verbunden wird.

2. Verfahren nach Anspruch 1, **dadurch gekennzeichnet, dass** als Positioniervorrichtung (30) ein Keil (43) verwendet wird, der zwischen die Teilbereiche (8a, 8b) und durch das Aufnahmefenster (4) taucht, wobei die Teilbereiche (8a, 8b) voneinander weg gespreizt werden.

3. Verfahren nach Anspruch 1, **dadurch gekennzeichnet, dass** als die Positioniervorrichtung (30) eine Spreizgabel mit Spreizgabelzinken (41) verwendet wird, die zwischen die Teilbereiche (8a, 8b) und durch das Aufnahmefenster (4) hindurchtaucht, wobei die Teilbereiche (8a, 8b) durch Öffnen zum Rand des Aufnahmefensters (4) hin spreizend versetzt werden.

4. Verfahren nach Anspruch 1, **dadurch gekennzeichnet, dass** als Positioniervorrichtung (30) ein Paar von Hakeneinrichtungen (31) verwendet wird, wobei je eine Hakeneinrichtung (31) mit einem Teilbereich (8a, 8b) zusammenwirkt und dieser mit der Hakeneinrichtung (31) aus dem Zentrumsbereich (Z) zum benachbarten Rand (23a, 23b) hin versetzt wird.

5. Verfahren nach Anspruch 4, **dadurch gekennzeichnet, dass** als die Hakeneinrichtung (31) ein Paar von Hakengabeln (31) verwendet wird und zum Verbinden der Teilbereiche (8a, 8b) mit den Anschlussflächen (22a, 22b) eine Befestigungseinrichtung, z. B. eine Schweißelektrode (35) zwischen Zinken der Hakengabeln (31) auf den Drahtleiter (6) einwirkt.

6. Verfahren nach einem der vorangegangenen Ansprüche, **dadurch gekennzeichnet, dass** die Positioniervorrichtung (30) vor dem Einsetzen des Chipmoduls (5) außer Eingriff mit den Teilbereichen (8a, 8b) gebracht wird.

7. Verfahren nach einem der vorangegangenen Ansprüche, **dadurch gekennzeichnet, dass** der Teilbereich (8a, 8b) beim Spreizen ein Stück vertikal zur Oberfläche des Substrats (3) angehoben wird.

8. Verfahren nach einem der vorangegangenen Ansprüche, **dadurch gekennzeichnet, dass** die Teilbereiche (8a, 8b) aus ihrer Anfangsposition unterschiedlich weit auf den benachbarten Rand (23a, 23b) hin versetzt werden.

9. Verfahren nach einem der vorangegangenen Ansprüche, **dadurch gekennzeichnet, dass** die Befestigung der Drahtleiter (6) auf dem Substrat (3) in einem Randbereich (U) um das Aufnahmefenster (4) schwächer ausgebildet ist als im übrigen Bereich des Substrates (3).

10. Verfahren nach einem der vorangegangenen Ansprüche, **dadurch gekennzeichnet, dass** der Drahtleiter (6) beim Spreizen um Kanten (39) der Positioniervorrichtung (30) mit engen Radien plastisch verformt wird.

## Revendications

1. Procédé pour connecter au moins un conducteur en fil (6) avec au moins un dispositif terminal (22a, 22b) sur un module à puce (5) pour produire un dispositif transpondeur (1) comprenant un dispositif à bobine (2) et ledit module à puce (5), dans lequel, dans une première étape, le dispositif à bobine (2) est disposé et fixé sur un substrat (3), et dans une autre étape, le conducteur en fil (6) du dispositif à bobine (2) est connecté au module à puce (5), grâce à quoi pendant la première étape du procédé, des portions terminales (7a, 7b) du conducteur en fil (6) sont posées de manière à s'étendre à travers une fenêtre de réception (4) dans une relation en écartement dans une zone centrale (Z) de la fenêtre de réception (4) pour le module à puce (5), des zones partielles (8a, 8b) du conducteur en fil (6) qui s'étendent à travers la fenêtre de réception (4) sont déplacées depuis ladite zone centrale (Z) de manière à s'écarter vers un bord adjacent (23a, 23b) de la fenêtre de réception (4) au moyen d'un dispositif de positionnement (30) jusqu'à ce qu'au moins une section de la zone partielle (8a, 8b) s'étende au-dessus de la position désirée d'une zone terminale (22a, 22b), le module à puce (5) est ensuite inséré depuis le côté du substrat (3) qui est à l'opposé du côté du conducteur en fil (6) en pénétration dans la fenêtre de réception (4) et la section est alors connectée d'une manière électriquement conductrice avec la zone terminale (22a, 22b).

2. Procédé selon la revendication 1, **caractérisé en ce qu'**un coin (43) est utilisé à titre de dispositif de positionnement (30), qui s'enfonce entre les zones partielles (8a, 8b) et à travers la fenêtre de réception (4), de sorte que les zones partielles (8a, 8b) sont écartées en éloignement l'une de l'autre.

3. Procédé selon la revendication 1, **caractérisé en ce qu'**une fourche d'écartement avec des dents de fourche d'écartement (41) est utilisée à titre de dispositif de positionnement (30), qui s'enfonce entre les zones partielles (8a, 8b) et à travers la fenêtre de réception (4), de sorte que les zones partielles (8a, 8b) sont déplacées en écartement vers le bord de la fenêtre de réception (4) par ouverture.

4. Procédé selon la revendication 1, **caractérisé en ce qu'**une paire de dispositifs en crochet (31) est utilisée à titre de dispositif de positionnement (30), de sorte qu'un dispositif en crochet (31) coopère respectivement avec une zone partielle (8a, 8b) et cette dernière est déplacée depuis la zone centrale (Z) vers le bord adjacent (23a, 23b) au moyen du dispositif en crochet (31).

5. Procédé selon la revendication 4, **caractérisé en ce qu'**une paire de fourches en crochet (31) est utilisée à titre de dispositif en crochet (31), et **en ce qu'**un dispositif de fixation, par exemple une électrode de soudage (35), agit sur le conducteur en fil (6) entre les dents des fourches en crochet (31) afin de connecter les zones partielles (8a, 8b) avec les zones terminales (22a, 22b).

6. Procédé selon l'une quelconque des revendications précédentes, **caractérisé en ce que** le dispositif de positionnement (30) est amené hors d'engagement avec les zones partielles (8a, 8b) avant l'insertion du module à puce (5).

7. Procédé selon l'une quelconque des revendications précédentes, **caractérisé en ce que** la zone partielle (8a, 8b) est soulevée légèrement verticalement par rapport à la surface du substrat (3) pendant l'écartement.

8. Procédé selon l'une quelconque des revendications précédentes, **caractérisé en ce que** les zones partielles (8a, 8b) sont déplacées sur des distances différentes depuis leurs positions initiales vers le bord adjacent (23a, 23b).

9. Procédé selon l'une quelconque des revendications précédentes, **caractérisé en ce que** la fixation des conducteurs en fil (6) sur le substrat (3) est configurée pour être plus faible dans une zone marginale (U) autour de la fenêtre de réception (4) que dans la zone restante du substrat (3)

10. Procédé selon l'une quelconque des revendications précédentes, **caractérisé en ce que** le conducteur en fil (6) est déformé plastiquement autour des bords (39) du dispositif de positionnement (30), avec de faibles rayons pendant l'écartement.
